# EUROPÄISCHE PATENTSCHRIFT

(11) **EP 1 506 577 B1**
(45) Veröffentlichungstag und Bekanntmachung des Hinweises auf die Patenterteilung: **03.07.2013**
(21) Anmeldenummer: 03702319.9
(22) Anmeldetag: 10.01.2003
(51) Int. Cl.: H01L 23/488

(54) **VERBINDUNGSEINRICHTUNG ZUM KONTAKTIEREN EINES HALBLEITER-BAUELEMENTES**
CONNECTING DEVICE FOR CONTACTING A SEMICONDUCTOR COMPONENT
DISPOSITIF DE CONNEXION PERMETTANT LA MISE EN CONTACT D'UN COMPOSANT A SEMICONDUCTEUR

(30) Priorität: 11.05.2002 DE 10221085
(43) Veröffentlichungstag der Anmeldung: 16.02.2005
(73) Patentinhaber: ROBERT BOSCH GMBH, 70442 Stuttgart (DE)
(72) Erfinder: HAUENSTEIN, Henning, 72762 Reutlingen (DE); BALSZUNAT, Dirk, 70569 Stuttgart (DE)
(86) Internationale Anmeldenummer: PCT/DE2003/000052
(87) Internationale Veröffentlichungsnummer: WO 2003/096417

(56) Entgegenhaltungen:
- US-A- 5 010 388
- US-A- 5 126 820
- US-A- 5 528 456

## Beschreibung

Die Erfindung betrifft eine Verbindungseinrichtung zum Kontaktieren eines Halbleiter-Bauelementes mit mindestens einem weiteren Bauteil und ein Verfahren zum Herstellen einer derartigen Verbindungseinrichtung.

Bei modernen Anwendungen werden Leistungsbauelemente mit hoher Stromtragfähigkeit benötigt. Bei Halbleitertechnologien, die sehr hohe Leistungen schalten können, müssen hohe Stromdichten und die durch Verlustleistung auftretende Wärme über eine geeignete Aufbau- und Verbindungstechnologie vom Chip an die Umgebung abgeführt werden. Herkömmliche Verbindungstechniken bzw. Bondtechniken sind teuer und zeitaufwendig und stellen insbesondere einen Engpass für den vom Chip abzuführenden Strom dar. Eine gute Wärmekontaktierung erfolgt bisher im Allgemeinen über eine großflächig gelötete Chiprückseite. Hierbei werden Montagetechniken verwendet, die zum Beispiel durch beidseitig großflächige Montage des Chips sowohl eine gute Strom- als auch Wärmekontaktierung ermöglichen.

Als Verbindungseinrichtung für die Kontaktierung des Halbleiter-Bauelementes mit einem weiteren Bauteil der Baugruppe kann insbesondere ein kostengünstig herstellbarer metallischer Leiterrahmen (Leadframe) verwendet werden, der zum Beispiel als Stanzgitter hergestellt wird. Die verschiedenen Anschlussbereiche bzw. Kontaktbereiche des Halbleiter-Bauelementes können direkt auf zum Beispiel innere Enden der Verbindungsstreifen des Leiterrahmens gelötet werden. Nachteilhaft an der Verwendung derartiger metallischer Leiterrahmen ist jedoch insbesondere die im Allgemeinen stärkere Ausdehnung des Metalls gegenüber dem Silizium des Halbleiter-Bauelementes, so dass aufgrund der im Betrieb erreichbaren Temperaturintervalle in dem auf der Chipoberfläche angebrachten metallischen Verbindungsstreifen und/oder seiner Grenzfläche mit einer Kontaktschicht aus Lot oder leitfähigem Klebstoff thermische Spannungen und Defekte auftreten können.

Weiterhin sind Materialien bekannt, mit denen beidseitige Lötungen vorgenommen werden können, wie zum Beispiel DBC (Direct-Bonded-Copper)-Keramiken. Derartige speziell behandelte Keramiken oder Thermal-Clad-Substrate sind jedoch im allgemeinen aufwendig in der Herstellung und kostenträchtig.

Ein weiterer relevanter Stand der Technik wird in dem Dokument US-A-5 126 820 gezeigt. Es offenbart eine Verbindungseinrichtung zum Kontaktieren eines Halbleiter-Baulementes mit mindestens einem weiteren Bauteil, wobei die Verbindungseinrichtung ein zentrales "die paddle" und damit verbundene "support fingers" aufweist. Das zentrale "die paddle" weist einem Kontaktbereich zur Aufbringung auf einem Anschlussbereich des Halbleiter-Bauelementes aufweist, wobei der Kontaktbereich strukturiert ist. Die "support fingers" sind nicht weiter strukturiert. Der Kontaktbereich bildet eine Verformungsreserve in der Anschlussebene aus, indem im Kontaktbereich entweder Nuten, oder Ausnehmungen in Form von Schlitzen vorgesehen sind.

Die erfindungsgemäße Verbindungseinrichtung nach Anspruch 1 und das erfindungsgemäße Verfahren nach Anspruch 7 weisen demgegenüber insbesondere den Vorteil auf, dass eine einfache und kostengünstige Herstellung möglich ist und dennoch eine direkte und relativ spannungsfreie Anbringung auf der Chipoberfläche ermöglicht ist. Die Unteransprüche beschreiben bevorzugte Weiterbildungen. Hierbei wird insbesondere nach Anspruch 4 eine Baugruppe mit mindestens einem Halbleiter-Bauelement und mindestens einem weiteren Bauteil geschaffen, deren Anschlussbereiche über die erfindungsgemäße Verbindungseinrichtung kontaktiert sind.

Erfindungsgemäß wird eine Verbindungseinrichtung mit metallischen Verbindungsstreifen, insbesondere ein metallischer Leiterrahmen zur Kontaktierung der Anschlussbereiche des Halbleiter-Bauelementes, verwendet, so dass keine aufwendigen und kostspieligen zusätzlichen Materialien, wie zum Beispiel DBC-Keramiken, erforderlich sind. Um die eingangs beschriebenen Nachteile bei der Verwendung metallischer Verbindungen, insbesondere die mechanischen Spannungen großflächiger Verbindungen bei der Kontaktierung von Halbleiter-Bauelementen mit hohen Stromdichten und Verlustleistungen, zu-mindest weitgehend zu verringern, wird der Kontaktbereich der Verbindungseinrichtung strukturiert und gegenüber Spannungen, die in einer zu dem Anschlussbereich parallelen Anschlussebene verlaufen, nachgiebig ausgebildet.

Eine derartige Strukturierung erfolgt durch Ausbildung einer mechanischen Verformungsreserve innerhalb des Kontaktbereiches, die die mechanischen Spannungen durch ihre Nachgiebigkeit direkt abfangen kann. Die Strukturierung kann insbesondere durch Ausbildung von Wellen bzw. wellenartigen Bereichen erfolgen, bei denen eine dem Halbleiter-Bauelement zugewandte Oberfläche des Kontaktbereiches gegenüber der Oberfläche des Anschlussbereiches vergrößert ist. Derartige Wellen können entsprechend den zu erwartenden thermischen Verspannungen in unterschiedlicher Weise ausgerichtet sein. Sie können sich zum Beispiel in Wesentlichen in Längsrichtung des Verbindungsstreifens erstrecken, um insbesondere laterale Verspannungen abzufangen. Bei größeren Anschlussbereichen, die insbesondere auch eine größere Längserstreckung aufweisen, können weiterhin thermische Spannungen auch durch eine oder mehrere sich quer zu der Längsrichtung des Verbindungsstreifens erstreckende Wellen abgefangen werden.

Alternativ zu derartigen Strukturierungen mit vergrößerter Oberfläche durch Wellen usw., d.h. Materialanhäufungen einer planen Ebene, kann grundsätzlich auch eine Materialverringerung durch geeignete Ausnehmungen vorgesehen sein, z. B. sich in Längs- oder Querrichtung erstreckende Schlitze und/oder kreuzförmige Schlitze, die eine Nachgiebigkeit gegenüber Spannungen durch eine geeignete Verformung ermöglichen.

Die Anbindung des strukturierten Kontaktbereichs an den Anschlussbereich des Halbleiterbauelementes kann durch Lot oder leitfähigen Klebstoff als Kontaktschicht erfolgen. Die Kontaktschicht kann hierbei lediglich in Teilflächen zwischen dem Anschlussbereich und Auflagebereichen des strukturierten Kontaktbereiches erfolgen; weiterhin ist auch eine großflächige Beschichtung des Anschlussbereichs mit der Kontaktschicht möglich, wobei ein Zwischenraum zwischen dem Anschlussbereich des Halbleiter-Bauelementes und dem strukturierten Kontaktbereich freigelassen oder mit der Kontaktschicht aufgefüllt sein kann, was zum Beispiel durch Aufpressen des strukturierten Kontaktbereichs auf eine größere Materialmenge des leitfähigen Klebstoffes oder Lotes erreicht werden kann.

Die Erfindung wird im Folgenden anhand der beiliegenden Zeichnungen an einigen Ausführungsformen näher erläutert. Es zeigen:

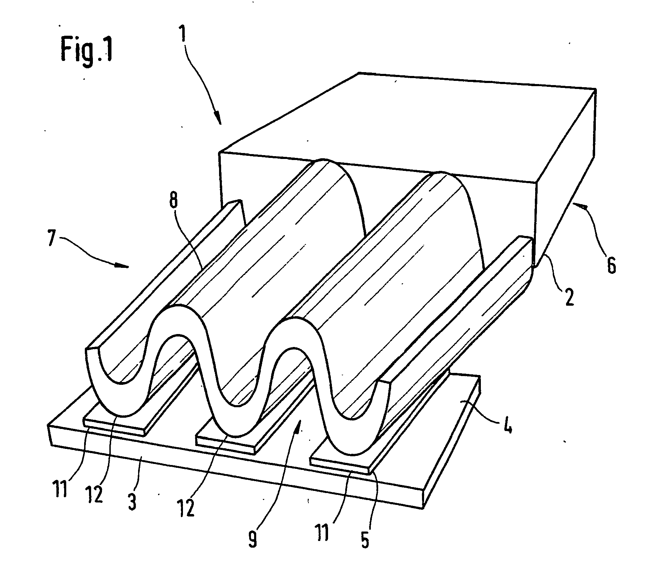

- Fig. 1: eine perspektivische Ansicht eines Teilbereichs eines Halbleiter-Bauelementes mit einer erfindungsgemäßen Verbindungseinrichtung gemäß einer Ausführungsform;
- Fig. 2: eine entsprechend perspektivische Ansicht gemäß einer weiteren Ausführungsform.

Eine Baugruppe 1 weist als Halbleiter-Bauelement einen Silizium-Chip 3 auf, der in nicht weiter gezeigter Weise strukturiert ist, wobei auf seiner Oberseite ein Anschlussbereich 4 als Metallschicht zur Kontaktierung mit externen Bauelementen ausgebildet ist.

Auf den Anschlussbereich 4 ist eine Kontaktschicht 5 aus Lot oder leitfähigem Klebstoff aufgetragen, die mehrere, sich parallel in Längsrichtung erstreckende Teilflächen 11 aufweist. Auf der Kontaktschicht 5 ist ein als Metallkontakt dienender metallischer Verbindungsstreifen 2 aufgebracht, der in Kontaktflächen 12 auf den Teilflächen 11 aufliegt. Der Verbindungsstreifen 2 erstreckt sich in einer Längsrichtung und verbindet den Anschlussbereich 4 mit entsprechenden Anschlussbereichen eines weiteren Bauteils. Der metallische Verbindungsstreifen 2 ist hierbei Teil eines Leiterrahmens bzw. Leadframes zur Kontaktierung mehrerer Anschlussbereiche.

Der metallische Verbindungsstreifen 2 weist einen unstrukturierten Bereich 6, der sich über eine größere Länge zu dem anderen Bauteil hin erstreckt, und einen Kontaktbereich 7 auf, der auf dem Anschlussbereich 4 befestigt wird. Der Kontaktbereich 7 ist hierbei strukturiert, indem gegenüber dem unstrukturierten Bereich 6 Material entfernt ist. Hierbei wird eine Struktur mit mehreren, sich in Längsrichtung erstreckenden Wellen 8 ausgebildet, die gegenüber Verformungen in lateraler Richtung bzw. Querrichtung eine Verformungsreserve bilden. Die gebildete Wellenstruktur kann eine gleichmäßige Dicke oder auch eine ungleichmäßige Dicke, zum Beispiel mit dickeren Bereichen entlang der Kammbereiche, aufweisen. Hierdurch wird somit eine wellige, wellenartige oder wellblechartige Struktur erreicht. Temperaturänderungen, insbesondere Temperaturerhöhungen durch den elektrischen Strom, der durch den Anschlussbereich 4, die Kontaktschicht 5, den strukturierten Kontaktbereich 7 und den unstrukturierten Bereich 6 fließt, führen zu einer Verformung des strukturierten Kontaktbereiches 7, ohne dass die Kontaktflächen 12 von den Teilflächen 11 gelöst werden.

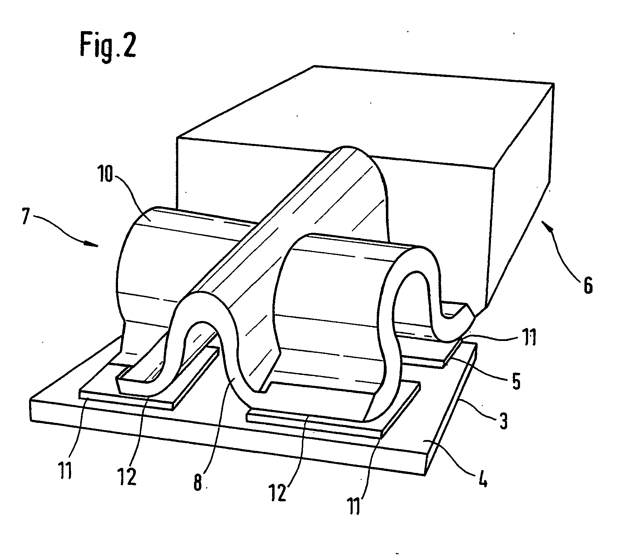

Bei der in Fig. 2 gezeigten Ausführungsform ist in dem strukturierten Kontaktbereich 7 eine sich in Längsrichtung erstreckende Welle 8 ausgebildet. Weiterhin sind ein oder mehrere sich in Querrichtung erstreckende Wellen 10 ausgebildet, die in die Welle 8 übergehen. Eine derartige Struktur kann auch - insbesondere bei gleicher Höhe der Wellen 8, 10 als kreuzartige Struktur ausgebildet sein, die eine Verformungsreserve für durch Spannungen bedingte Verzerrungen sowohl in Längs- als auch in Querrichtung aufweist und somit jegliche Spannungen parallel zum Anschlussbereich 4 abfangen kann. Alternativ zu der in Fig. 2 gezeigten Kreuzstruktur kann z. B. auch eine komplementäre Struktur ausgebildet sein, die in mittleren Abschnitten des strukturierten Kontaktbereichs 7 eine Vertiefung statt der in Fig. 2 gezeigten Erhöhung aufweist.

Zur Herstellung der verschiedenen Ausführungsformen kann zunächst in an sich bekannter Weise ein Leiterrahmen (Leadframe) durch ein Stanz-, Press- oder Fließpressverfahren hergestellt werden, dessen Kontaktbereiche 7 nachfolgend durch ein geeignetes Materialbearbeitungsverfahren strukturiert werden. Hierbei kann zum Beispiel ein Laserschneidverfahren oder Ätzverfahren angewendet werden.

## Patentansprüche

1. Verbindungseinrichtung zum Kontaktieren eines Halbleiter-Bauelementes mit mindestens einem weiteren Bauteil, wobei die Verbindungseinrichtung mehrere, sich in einer jeweiligen Längsrichtung erstreckende metallische Verbindungsstreifen (2) zum Kontaktieren verschiedener Anschlussbereiche (4) des Halbleiter-Bauelementes (3) aufweist, wobei die metallischen Verbindungsstreifen jeweils einen unstrukturierten Bereich (6) und einen Kontaktbereich (7) zur Aufbringung auf einem Anschlussbereich (4) des Halbleiter-Bauelementes (3) aufweisen, wobei der Kontaktbereich (7) strukturiert ist, um eine Verformungsreserve (8) in der Anschlussebene auszubilden, indem der strukturierte Bereich (7) einen oder mehrere wellenförmige Bereiche (8) aufweist, wobei sich mehrere parallele, wellenförmige Bereiche (8) in Längsrichtung erstrecken und/oder mindestens ein wellenförmiger Bereich sich quer zur Längsrichtung erstreckt, oder indem im Kontaktbereich Ausnehmungen in Form von sich in Längs- oder quer zur Längsrichtung des metallischen Verbindungsstreifens erstreckende Schlitze und/oder kreuzförmige Schlitze vorgesehen sind.

2. Verbindungseinrichtung nach Anspruch 1, **dadurch gekennzeichnet, dass** sie als Stanzgitter und/oder Pressgitter ausgebildet ist.

3. Verbindungseinrichtung nach einem der vorherigen Ansprüche, **dadurch gekennzeichnet, dass** die Kontaktbereiche (7) durch Materialbearbeitungsverfahren, vorzugsweise Ätzverfahren und/oder Laserschneidverfahren, strukturiert sind.

4. Baugruppe mit mindestens einem Hableiter-Bauelement (3) und mindestens einem weiteren Bauteil, wobei Anschlussbereiche des Halbleiterbauelements über eine Verbindungseinrichtung nach einem der vorherigen Ansprüche mit Anschlussbereichen des weiteren Bauteils kontaktiert sind.

5. Baugruppe nach Anspruch 4, **dadurch gekennzeichnet, dass** eine zwischen dem Anschlussbereich (4) des Halbleiter-Bauelementes (3) und dem strukturierten Bereich (7) vorgesehene Kontaktschicht (5), vorzugsweise ein Lot oder ein leitfähiger Klebstoff, strukturiert ist.

6. Baugruppe nach Anspruch 5, **dadurch gekennzeichnet, dass** die Kontaktschicht (5) in vorzugsweise parallele Teilflächen (11) unter Kontaktflächen (12) des strukturierten Bereichs (7) auf dem Anschlussbereich (4) aufgetragen ist.

7. Verfahren zum Herstellen einer Verbindungseinrichtung nach einem der Ansprüche 1 bis 3, bei dem eine Gitter-Rohform durch ein Stanzverfahren, Pressverfahren und/oder Fliesspressverfahren aus einem metallischen Werkstoff hergestellt wird, und nachfolgend an äußeren Enden der Verbindungseinrichtung strukturierte Bereiche (7) durch ein Materialbearbeitungsverfahren, zum Beispiel Laserschneidverfahren oder Ätzverfahren, ausgebildet werden, derart dass die Verbindungseinrichtung mehrere, sich in einer jeweiligen Längsrichtung erstreckende metallische Verbindungsstreifen (2) zum Kontaktieren verschiedener Anschlussbereiche (4) des Halbleiter-Bauelementes (3) aufweist, wobei die metallischen Verbindungsstreifen jeweils einen unstrukturierten Bereich (6) und den strukturierten Bereich (7) als Kontaktbereich (7) zur Aufbringung auf einem Anschlussbereich (4) des Halbleiter-Bauelementes (3) aufweisen, wobei die Kontaktbereiche (7) strukturiert sind, um eine Verformungsreserve (8) in der Anschlussebene ausbilden, indem der strukturierte Bereich (7) einen oder mehrere wellenförmige Bereiche (8) aufweist, wobei sich mehrere parallele, wellenförmige Bereiche (8) in Längsrichtung erstrecken und/oder mindestens ein wellenförmiger Bereich sich quer zur Längsrichtung erstreckt, oder indem im Kontaktbereich Ausnehmungen in Form von sich in Längs- oder quer zur Längsrichtung des metallischen Verbindungsstreifens erstreckende Schlitze und/oder kreuzförmige Schlitze vorgesehen sind.

## Claims

1. Connecting device for establishing contact between a semiconductor component and at least one further component, wherein the connecting device has a plurality of metal connecting strips (2), which extend in a respective longitudinal direction, for making contact with a variety of connection regions (4) of the semiconductor component (3), wherein the metal connecting strips each have an unpatterned region (6) and a contact region (7) to be applied to a connection region (4) of the semiconductor component (3), wherein the contact region (7) is patterned, in order to form a deformation space (8) in the connection plane, by the patterned region (7) having one or more corrugated regions (8), wherein a plurality of parallel, corrugated regions (8) extend in the longitudinal direction and/or at least one corrugated region extends transverse to the longitudinal direction, or by recesses in the form of slots which extend in the longitudinal direction or transverse to the longitudinal direction of the metal connecting strip and/or cross-shaped slots being provided in the contact region.

2. Connecting device according to Claim 1, **characterized in that** it is in the form of a stamped grid and/or pressed grid.

3. Connecting device according to either of the preceding claims, **characterized in that** the contact regions (7) are patterned by material-processing methods, preferably etching methods and/or laser-cutting methods.

4. Assembly having at least one semiconductor component (3) and at least one further component, wherein contact is established between connection regions of the semiconductor component and connection regions of the further component by means of a connecting device according to one of the preceding claims.

5. Assembly according to Claim 4, **characterized in that** a contact layer (5) which is provided between the connection region (4) of the semiconductor component (3) and the patterned region (7), preferably a solder or a conductive adhesive, is patterned.

6. Assembly according to Claim 5, **characterized in that** the contact layer (5) is applied to the connection region (4) in preferably parallel partial areas (11) beneath contact areas (12) of the patterned region (7).

7. Method for producing a connecting device according to one of Claims 1 to 3, in which method a grid blank is produced from a metal material by a stamping process, pressing process and/or extrusion process, and patterned regions (7) are then formed at outer ends of the connecting device by a material-processing method, for example a laser-cutting method or etching method, in such a way that the connecting device has a plurality of metal connecting strips (2), which extend in a respective longitudinal direction, for making contact with a variety of connection regions (4) of the semiconductor component (3), wherein the metal connecting strips each have an unpatterned region (6) and the patterned region (7) as a contact region (7) to be applied to a connection region (4) of the semiconductor component (3), wherein the contact regions (7) are patterned, in order to form a deformation space (8) in the connection plane, by the patterned region (7) having one or more corrugated regions (8), wherein a plurality of parallel, corrugated regions (8) extend in the longitudinal direction and/or at least one corrugated region extends transverse to the longitudinal direction, or by recesses in the form of slots which extend in the longitudinal direction or transverse to the longitudinal direction of the metal connecting strip and/or cross-shaped slots being provided in the contact region.

## Revendications

1. Dispositif de connexion pour la mise en contact d'un composant à semiconducteur avec au moins un autre composant, le dispositif de connexion présentant plusieurs rubans de connexion métalliques (2) s'étendant dans une direction longitudinale respective pour la mise en contact de différentes régions de raccordement (4) du composant à semiconducteur (3), les rubans de connexion métalliques présentant à chaque fois une région non structurée (6) et une région de contact (7) devant être appliquée sur une région de raccordement (4) du composant à semiconducteur (3), la région de contact (7) étant structurée pour constituer une réserve de déformation (8) dans le plan de raccordement, la région structurée (7) présentant à cet effet une ou plusieurs régions ondulées (8), plusieurs régions ondulées parallèles (8) s'étendant dans la direction longitudinale et/ou au moins une région ondulée s'étendant transversalement à la direction longitudinale, ou des évidements en forme de fentes s'étendant dans la direction longitudinale ou transversalement à la direction longitudinale du ruban de connexion métallique et/ou de fentes cruciformes étant prévus à cet effet dans la région de contact.

2. Dispositif de connexion selon la revendication 1, **caractérisé en ce qu'**il est réalisé sous forme de réseau estampé et/ou pressé.

3. Dispositif de connexion selon l'une quelconque des revendications précédentes, **caractérisé en ce que** les régions de contact (7) sont structurées par des procédés de traitement de matériau, de préférence des procédés de gravure et/ou de découpe au laser.

4. Module comprenant au moins un composant à semiconducteur (3) et au moins un autre composant, des régions de raccordement du composant à semiconducteur étant mises en contact par le biais d'un dispositif de connexion selon l'une quelconque des revendications précédentes avec des régions de raccordement de l'autre composant.

5. Module selon la revendication 4, **caractérisé en ce qu'**une couche de contact (5) prévue entre la région de raccordement (4) du composant à semiconducteur (3) et la région structurée (7), de préférence une brasure ou un adhésif conducteur, est structurée.

6. Module selon la revendication 5, **caractérisé en ce que** la couche de contact (5) est appliquée sur la région de raccordement (4) dans des surfaces partielles de préférence parallèles (11) sous des surfaces de contact (12) de la région structurée (7).

7. Procédé de fabrication d'un dispositif de connexion selon l'une quelconque des revendications 1 à 3, dans lequel un moule brute de réseau est fabriqué par un procédé d'estampage, de pressage et/ou de formage par fluage à partir d'un matériau métallique, et ensuite des régions structurées (7) sont réalisées aux extrémités extérieures du dispositif de connexion par un procédé de traitement de matériau, par exemple un procédé de découpe au laser ou de gravure, de telle sorte que le dispositif de connexion présente plusieurs rubans de connexion métalliques (2) s'étendant dans une direction longitudinale respective pour la mise en contact de différentes régions de raccordement (4) du composant à semiconducteur (3), les rubans de connexion métalliques présentant à chaque fois une région non structurée (6) et la région structurée (7) en tant que région de contact (7) devant être appliquée sur une région de raccordement (4) du composant à semiconducteur (3), les régions de contact (7) étant structurées pour constituer une réserve de déformation (8) dans le plan de raccordement, la région structurée (7) présentant à cet effet une ou plusieurs régions ondulées (8), plusieurs régions ondulées parallèles (8) s'étendant dans la direction longitudinale et/ou au moins une région ondulée s'étendant transversalement à la direction longitudinale, ou des évidements en forme de fentes s'étendant dans la direction longitudinale ou transversalement à la direction longitudinale du ruban de connexion métallique et/ou de fentes cruciformes étant prévus à cet effet dans la région de contact.
